# EUROPEAN PATENT APPLICATION

(11) **EP 1 895 605 A1**
(43) Date of publication of application: **05.03.2008**
(21) Application number: 06018268.0
(22) Date of filing: 31.08.2006
(51) Int. Cl.: H01L 41/047, H01L 41/083, H01L 41/22, H01L 41/24

(54) **Piezoceramic multilayer actuator**

(71) Applicant: SIEMENS AKTIENGESELLSCHAFT, 80333 München (DE)
(72) Inventor: Döllgast, Bernhard, 8530 Deutschlandsberg (AT); Inagaki, Masahiro, 899-43 Kagoshima (JP); Kastl, Harald Johannes, 95686 Fichtelberg (DE); Ochi, Atsushi, 224-0023 Yokohama (JP); Sakamoto, Takami, 899-43 Kagoshima (JP); Schuh, Carsten, Dr., 85598 Baldham (DE)

(57) **Abstract**

A piezoceramic multilayer actuator comprises at least two piezoceramic layers (12) and an internal electrode (14, 16) arranged between the at least two piezoceramic layers (12), the internal electrode (14, 16) comprising an electrode material, wherein the liquidus temperature of the electrode material is higher than a sintering temperature of the piezoceramic layers (12), and the solidus temperature of the electrode material is lower than the sintering temperature of the piezoceramic layer (12).

## Description

The present invention refers to a piezoceramic multilayer actuator comprising a stack of a plurality of piezoceramic layers and at least one internal electrode arranged between the piezoceramic layers. The present invention addresses the problem of mechanical stress inside the piezoceramic multilayer actuator and the cracks resulting from this stress.

Piezoceramic actuators are used and optimized for a large number of applications in virtually all fields of technology. The application of an electrical field to the piezoceramic actuator results in a geometrical distortion, particularly in a change of length and height. In order to reduce the voltage to be applied to the actuator and/or increase its distortion, piezoceramic actuators usually comprise a large number of thin piezoceramic layers and internal electrodes arranged alternatingly in a stack.

During manufacturing, the piezoceramic layers are provided as green sheets and laminated with the internal electrodes to form a stack. The stack is burned or heated to a sintering temperature of the piezoceramic layers thereby transferring the sheets from the green state to the ceramic state. External electrodes are deposited on or arranged at lateral surfaces of the stack and connected to the internal electrodes in an electrically conductive way. Each internal electrode is connected to only one of the (at least) two external electrodes. This is achieved by providing the internal electrodes in such a way that the edge of an internal electrode which is to be connected to an external electrode on the lateral surface is flush with this lateral surface while there is provided a distance between the edge of an internal electrode and a lateral surface if the internal electrode is to be electrically insulated from an external electrode on this lateral surface.

Particularly due to temperature gradients during the cooling phase after the sintering process and due to lateral inhomogeneities within the piezoceramic layers (e. g. microstructural differences), mechanical stress within the stack arises.

After baking the stack of piezoceramic layers, a high electrical field is applied to the piezoceramic layers by applying a corresponding electrical voltage to the internal electrodes via the external electrodes. The value of the electrical field is selected such that a permanent electrical polarization and a permanent distortion of the piezoceramic layers remain after switching off the electrical field. This procedure is called poling.

Since the internal electrodes do not extend to all lateral surfaces of the stack, the piezoceramic layers are not exposed to a lateral homogeneous electrical field and are not polarized and distorted in a laterally homogeneous way. Rather, close to the lateral surfaces, mechanical stress inside the piezoceramic layers results. This mechanical stress is further increased during operation of the piezoceramic actuator. Cracks occur in the stack both inside the piezoceramic layers and along the internal electrodes and frequently cause a failure of the piezoceramic actuator.

It is an object of the present invention to reduce the risk of failure of a piezoceramic multilayer actuator.

This object is solved by a piezoceramic multilayer actuator according to claim 1 and a method for manufacturing a piezoceramic multilayer actuator according to claim 6.

According to the present invention, a piezoceramic multilayer actuator comprises at least two piezoceramic layers and an internal electrode arranged between the at least two piezoceramic layers, the internal electrode comprising an electrode material, wherein the liquidus temperature of the electrode material is higher than a sintering temperature of the piezoceramic layers, and the solidus temperature of the electrode material is lower than the sintering temperature of the piezoceramic layer.

Further, the present invention provides a method for manufacturing a piezoceramic multilayer actuator, the method comprising:
providing at least two piezoceramic layers;
providing an electrode material between the at least two piezoceramic layers;
laminating the at least two piezoceramic layers and the electrode material between the at least two piezoceramic layers, thereby forming a stack, the electrode material forming an internal electrode within the piezoceramic stack; and
baking the stack at a baking temperature above the solidus temperature of the electrode material and below the liquidus temperature of the electrode material, thereby forming the piezoceramic multilayer actuator.

The present invention is based on the idea to keep the electrode material in a pasty condition while sintering the piezoceramic layers. This is achieved by a two (or more) phases electrode material providing a solidus temperature below the sintering temperature and a liquidus temperature higher than the sintering temperature of the piezoceramic layers. During the sintering step, the electrode material comprises a solid phase comprising small solid (crystalline) particles and a second, liquid phase. In this pasty condition, the electrode material cannot drop out of the multilayer structure of the stack. On the other hand, the electrode material is soft enough to avoid the build-up of any internal stress in the stack during the sintering procedure.

In order to avoid the electrode material flowing or dropping out of the structure during the sintering process, it is advantageous to select the electrode material and the properties of the surfaces of piezoceramic layers such that the surface tention of the partially molten electrode material on the piezoceramic layer surfaces is low or at least as low as reasonably achievable. A negative surface tension is the optimum. In this way, the internal electrode material is kept within the stack when it is partially molten during the sintering process.

The present invention is further based on the idea to select the internal electrode material and the piezoceramic layer material such that the solidus temperature of the internal electrode material or its eutectic temperature (in case of an eutectic alloy) is above the operating temperature of the stack but below the curie temperature of the piezoceramic layer material. Thereby, an annealing step during or after the poling of the piezoceramic layers is facilitated. In this annealing step, the stack is heated to a temperature above the solidus temperature of the internal electrode material but below the curie temperature. All internal stresses caused by the polarization and the resulting distortion of the piezoceramic layers are reduced or even vanish while the inner electrodes are in the above described partially molten and pasty condition in which they do not transfer any sheer stress.

This reduction or even elimination of stack internal stresses considerably reduces the likeliness of cracks inside the stack. In this way, the risk of a failure is reduced and the reliability and the life time of the piezoceramic multilayer actuator are improved.

Fuel injectors of internal combustion engines are an important application of piezoceramic multilayer actuators. The piezoceramic multilayer actuator directly actuates or at least indirectly controls the fuel valve and the injection process. Any failure of the piezoceramic multilayer actuator is a failure of the injector and causes the necessity to replace the entire injector. The costs of this measure are extremely disproportionate to the price of the bare piezoceramic multilayer actuator.

On the other hand, the present invention causes only minor additional costs. In particular, the suggested alloys (e. g. silver plus copper or silver plus tin) are inexpensive since they comprise inexpensive components. At least when taking into account the improvement of the yield and the reduction of rejects caused by the present invention, the present invention even reduces the production costs and the price of piezoceramic multilayer actuators.

According to the present invention, either all the internal electrodes of a piezoceramic multilayer actuator or rather the security electrodes are provided or manufactured in the above described way. In case of the application of the present invention to security electrodes, thin (a few millimetres) sub-stacks laminated with conventional internal electrodes are connected by and laminated with security electrodes formed in the above-described way.

These and other objects and features of the present invention will become clear from the following description taken in conjunction with the accompanying drawings in which:
- Figure 1: is a schematic view of a vertical cross section of a piezoceramic multilayer actuator;
- Figure 2: is a schematic view of a part of a vertical cross section of a piezoceramic multilayer actuator; and
- Figure 3: is a schematic flow chart of a method for manufacturing a piezoceramic multilayer actuator.

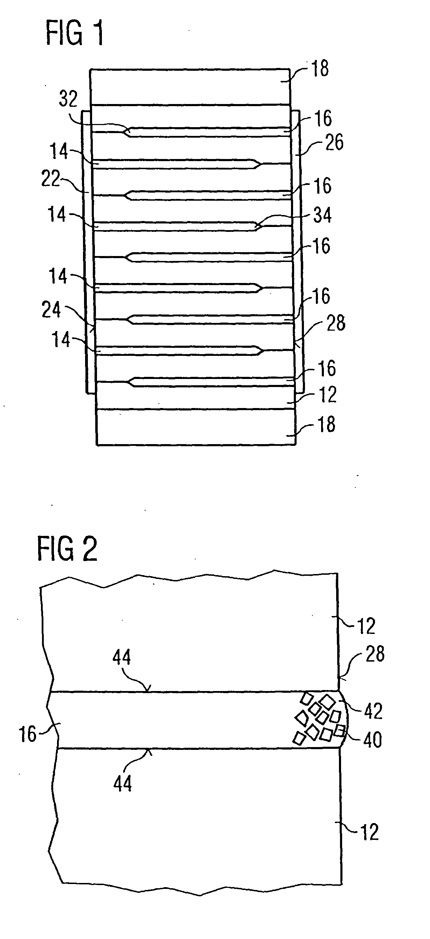

Fig. 1 is a schematic view of a cross section of a piezoceramic multilayer actuator. The cross section displayed in Fig. 1 is vertical to the single layers of the actuator and parallel to its laminating direction. The piezoceramic multilayer actuator comprises a number of piezoceramic layers 12 and a number of internal electrodes 14, 16 forming a stack. The piezoceramic layers 12 and the internal electrodes 14, 16 are arranged in an alternating manner such that each internal electrode 14, 16 is sandwiched by two piezoceramic layers 12 and each piezoceramic layer 12 is sandwiched by two internal electrodes 14, 16 (apart from the top most and the lowest layers). Preferably the whole stack is sandwiched by two thick cover plates 18. While each piezoceramic layer 12 is several micrometer or several 10 micrometer thick and each internal electrode 14, 16 is even much thinner, each cover plate 18 is about one or several millimetres thick.

A first external electrode 22 is arranged on a first lateral surface 24 of the stack and the second external electrode 26 is arranged on a second lateral surface 28 of the stack. Every second electrode 14 is electrically connected to the first external electrode 22 and electrically insulated from the second external electrode 26. The other internal electrodes 16 are electrically connected to the second external electrode 26 and electrically insulated from the first external electrode 22. As far as an electrode 14, 16 is electrically insulated from one of the external electrodes 22, 26, this is achieved by an appropriate distance between the corresponding edge 32, 34 of the internal electrode 14, 16 from the corresponding lateral surface 24, 28 and external electrode 22, 26.

In order to manufacture the piezoceramic multilayer actuator described above with reference to Fig. 1, the subsequently described steps are executed wherein some of these steps may be modified or replaced by similar or other steps or left out.

The piezoceramic layers are preferably provided as green sheets. The internal electrodes 14, 16 are deposited on the piezoceramic layers 12 by a screen printing or any other appropriate method or provided as metallic films or foils. The piezoceramic layers 12 and the internal electrodes 14, 16 are laminated in order to form a stack with the properties described above with reference to Fig. 1. The stack is pressed in order to mechanically connect the layers 12, 14, 16 intimately. Then the stack is heated to a sintering temperature of the piezoceramic layers 12 thereby transferring the green sheets into the final piezoceramic material.

According to the present invention, the internal electrodes 14, 16 are made up from a material comprising two or more elements, in particular from an alloy comprising at least two different elements. The relative proportions of the elements are such that the solidus temperature of the internal electrode material i.e. the maximum temperature below which all components or phases of the internal electrode material are solid, is different from (i.e. lower than) the liquidus temperature of the internal electrode material i.e. the minimum temperature above which all components or phases of the material are liquid. This means that there is a temperature interval between the solidus temperature and the liquidus temperature in which the internal electrode material provides (at least) one solid phase and (at least) one liquid phase. This means that the internal electrode material is not an eutecticum. Examples for an internal electrode material are silver copper alloys and silver tin alloys.

Fig. 2 is a schematic view of a vertical cross section of a part of the stack described above with reference to Fig. 1 during the above described baking of the stack. The stack is baked at or heated to a sintering temperature of the piezoceramic layers 12 which is higher than the solidus temperature and lower than the liquidus temperature of the internal electrode 16 material. This means that the internal electrode material and the material of the piezoceramic layers 12 are selected such that the material of the piezoceramic layers 12 can be sintered (during an appropriate sintering duration) at a sintering temperature above the solidus temperature and below the liquidus temperature of the internal electrode material.

As already described above, within this interval between the solidus temperature and the liquidus temperature, the internal electrode material is in a partly but not completely molten and pasty state with a high viscosity. In this state, the internal electrode material comprises small crystalline or other solid particles 40 within a liquid phase 42. The viscosity of the internal electrode material can be easily set to an appropriate value by adjusting the sintering temperature within the interval between solidus temperature and liquidus temperature and by adjusting the relative proportions of the components of the internal electrode material.

Preferably the material of the piezoceramic layers 12 and the internal electrode material (particularly the liquid phase 42) are selected such that the surface tension, or specific energy of the interface, between the internal electrode material and a material of the piezoceramic layers 12 is as low as possible, preferably negative, in order to guarantee a complete wetting of the piezoceramic layers 12 by the internal electrode material. For this purpose, the surfaces 44 of the piezoceramic layers 12 can be coated with appropriate material films.

While the piezoceramic layers 12 are preferably provided and laminated as green sheets, as an alternative they are provided as sintered piezoceramic layers which need not to be burned or sintered anymore. In both cases heating the internal electrode material to a temperature above its solidus temperature and below its liquidus temperature results in a pasty state of the internal electrode material. In this pasty state the internal electrode material provides a high viscosity but does not transfer any sheer stress. Therefore, no stress can build up within the stack while the high viscosity prevents the internal electrode material from flowing or dropping out of the gap between the piezoceramic layers 12.

After the stack is laminated and baked as described above (or, alternatively, even before the baking step) external electrodes 22, 26 are arranged at the lateral surfaces 24, 28 of the stack and thereby electrically connected to internal electrodes 14, 16. After the baking step a high voltage is applied to the internal electrodes 14, 16 via the external electrodes 22, 26 in order to permanently polarize the material of the piezoceramic layers 12. After switching off this high voltage a permanent polarization and a permanent distortion of the piezoceramic layers 12 remains.

Since there is a distance between the edges 32, 34 of the internal electrodes 14, 16 and the lateral surfaces 24, 26 of the stack, the electrical field applied to the piezoceramic layers 12 and the resulting polarization and distortion is not laterally homogeneous in the piezoceramic layers 12. This results in mechanical stress within the stack and particularly in the regions near the lateral surfaces 24, 28 and the edges 32, 34 of the internal electrodes 14, 16. This mechanical stress causes cracks along the interfaces between the internal electrodes 14, 16 and the piezoceramic layers 12, along the interfaces between the active regions (piezoceramic layers 12 and internal electrodes 14, 16) and the cover plates 18 and within the piezoceramic layers 12. These cracks may appear immediately or later on during the operation of the piezoceramic multilayer actuator. The extreme operating conditions in injectors of internal combustion engines and at other applications of a piezoceramic multilayer actuator, in particular the highly dynamic large-signal driving conditions effectively support the occurrence and the growth of these cracks easily and frequently causing a failure of the piezoceramic multilayer actuator.

During or after the above described poling process, it is particularly advantageous to heat the stack to a temperature above the solidus temperature and the liquidus temperature again to release any mechanical stress caused by the poling process in the above described way. In order to not destroy the polarization of the piezoceramic layers 12, it is necessary that the curie temperature of the material of the piezoceramic layers 12 at which any permanent polarization of the piezoceramic layers 12 disappears is higher than the solidus temperature of the internal electrode material and the annealing temperature is lower than the curie temperature.

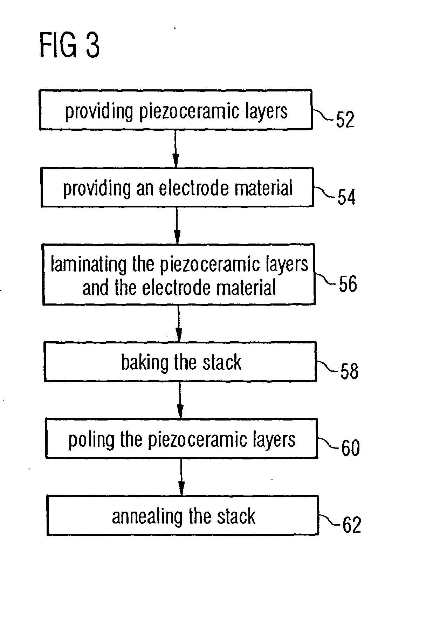

Fig. 3 is a schematic flow chart of a method for manufacturing a piezoceramic multilayer actuator as described above. In a first step 52, piezoceramic layers 12 are provided, preferably as green sheets. In a second step 54, an internal electrode material is provided for example by depositing the internal electrode material on the piezoceramic layers 12 by means of screen printing or any other method or as thin films. In a third step 56, the piezoceramic layers 12 and the internal electrode material are laminated to form a stack with the properties described above with reference to Fig. 1. In a fourth step 58, the stack is baked, or heated to an elevated temperature above the solidus temperature and below the liquidus temperature of the internal electrode material at which elevated temperature the piezoceramic layers 12 are sintered if they were originally provided as green sheets. At a fifth step 60 the piezoceramic layers are poled by applying an electrical field to the internal electrodes 14, 16. At a sixth step 62 the stack is annealed at a temperature above the solidus temperature and below the liquidus temperature of the internal electrode material and below the curie temperature of the piezoceramic layers 12. The sixth step may be carried out simultaneously or partly simultaneously with the fifth step.

## Claims

1. Piezoceramic multilayer actuator comprising:
at least two piezoceramic layers (12); and
an internal electrode (14, 16) arranged between the at least two piezoceramic layers (12), the internal electrode (14, 16) comprising an electrode material,
wherein the liquidus temperature of the electrode material is higher than a sintering temperature of the piezoceramic layers (12), and the solidus temperature of the electrode material is lower than the sintering temperature of the piezoceramic layer (12).

2. Piezoceramic multilayer actuator according to claim 1, wherein the eutectic temperature of the electrode material is lower than the curie temperature of the piezoceramic layers (12).

3. Piezoceramic multilayer actuator according to claim 1 or 2, wherein the solidus temperature of the electrode material is lower than the curie temperature of the piezoceramic layers (12).

4. Piezoceramic multilayer actuator according to one of the preceding claims, wherein the electrode material comprises silver and copper or silver and tin.

5. Method of manufacturing a piezoceramic multilayer actuator, the method comprising:
providing (52) at least two piezoceramic layers (12); providing (54) an electrode material between the at least two piezoceramic layers (12);
laminating (56) the at least two piezoceramic layers (12) and the electrode material between the at least two piezoceramic layers (12), thereby forming a stack, the electrode material forming an internal electrode (14, 16) within the piezoceramic stack; and
baking (58) the stack at a baking temperature above the solidus temperature of the electrode material and below the liquidus temperature of the electrode material, thereby forming the piezoceramic multilayer actuator.

6. Method according to claim 5,
wherein the at least two piezoceramic layers (12) are provided and laminated as green sheets, and
wherein the baking temperature is the sintering temperature of the green sheets.

7. Method according to claim 5 or 6, further comprising:
poling (60) the piezoceramic layers (12) by applying an electrical field to the piezoceramic layers (12) after baking the stack; and
heating (62) the stack to a temperature above the solidus temperature of the internal electrode (14, 16) and below the curie temperature of the piezoceramic layer (12) during or after the step of poling (60).
